# EUROPÄISCHE PATENTANMELDUNG

(11) **EP 2 196 555 A1**
(43) Veröffentlichungstag der Anmeldung: **16.06.2010**
(21) Anmeldenummer: 08020994.3
(22) Anmeldetag: 03.12.2008
(51) Int. Cl.: C23C 4/10, C23C 4/02, C03C 8/14, B23K 35/22, C03C 8/04

(54) **Pulvermischung aus Keramik und Glas, Bauteil mit Maskierung und Verfahren zur Anwendung**

(71) Anmelder: Siemens Aktiengesellschaft, 80333 München (DE)
(72) Erfinder: Steinbach, Jan, Dr., 13353 Berlin (DE)

(57) **Zusammenfassung**

Bisherige Maskierungen (7) weisen oft keine ausreichende Dichtheit auf um die Stellen (19), die nicht beschichtet werden sollen ausreichen zu schützen.

Eine Maskierung mit der erfindungsgemäßen Pulvermischung enthält Glas, das bei der Behandlungsmethode des Bauteils aufschmilzt und so eine dichte, feste Schicht bildet.

## Beschreibung

Die Erfindung betrifft eine Pulvermischung aus Keramik und Glas, ein Bauteil mit Maskierung sowie ein Verfahren zur Anwendung dieser Pulvermischung.

Bei Behandlungsmethoden von Bauteilen wie z.B. beim Schweißen oder auch beim Beschichten müssen oft bestimmte Bereiche vor dem Beschichtungsmaterial oder sonstigen Verschmutzungen geschützt werden.

Bekannt ist, dass Pulvermischungen aufgetragen werden. Jedoch besteht bei dem Auftragen von Pulvern das Problem, dass eine offene Porosität vorhanden ist, so dass weiterhin Dampf oder Beschichtungsmaterial auf die zu schützende Oberfläche gelangen kann.

Es ist daher Aufgabe der Erfindung dieses Problem zu überwinden.
Die Aufgabe wird gelöst durch eine Pulvermischung gemäß Anspruch 1, ein Bauteil nach Anspruch 8 und ein Verfahren gemäß Anspruch 12.

In den Unteransprüchen sind weitere vorteilhafte Maßnahmen aufgelistet, die jeweils beliebig miteinander kombiniert werden können, um weitere Vorteile zu erzielen.

Es zeigen:
- Figur 1, 2, 3: ein Bauteil mit einer Maskierung aus der Pulvermischung,
- Figur 4: eine Gasturbine,
- Figur 5: eine Turbinenschaufel,
- Figur 6: eine Brennkammer und
- Figur 7: eine Liste von Superlegierungen.
Die Beschreibung der Figuren stellen nur Ausführungsbeispiele der Erfindung dar.

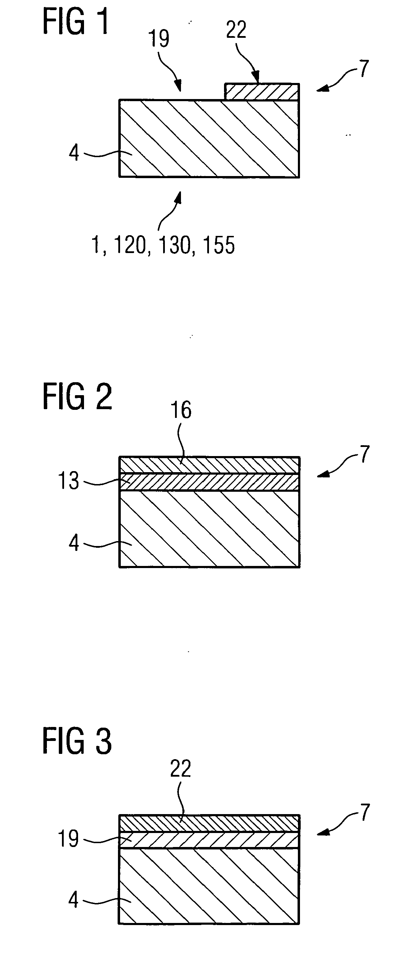

In Figur 1 ist ein Bauteil 1, 120, 130, 155 mit einem Substrat 4 gezeigt, das z.B. beim Beschichten in bestimmten Bereich 22 nicht beschichtet werden soll, sondern nur im Bereich 19.

Daher wird eine Maskierung 7 aufgetragen, die eine Pulvermischung aufweist.
Die Pulvermischung ist eine Mischung aus Keramik und Glas. Vorzugsweise werden Keramikpulver und/oder Glaspulver verwendet, die sich vorzugsweise als Paste oder Schlicker (mit oder ohne Binder) auftragen lassen.

Vorzugsweise werden Oxidkeramiken (= Metalloxid), Karbide oder Nitridkeramiken verwendet.

Vorzugsweise wird für die Keramik Aluminumoxid (Al₂O₃), Zirkonoxid (ZrO₂), Titanoxid (TiO₂) und/oder Bornitrid (BN) verwendet. Auch Gemische dieser Keramik werden vorzugsweise verwendet.

Am einfachsten wird nur ein einziges keramisches Pulver verwendet.

Als Glas wird vorzugsweise auf Siliziumoxid (SiO₂) basiertes Glas verwendet.

Bei dem Glas können vorzugsweise verschiedene Glassorten verwendet werden, um die Viskosität an die Temperaturen des Behandlungsverfahrens (Beschichten, Schweißen) einzustellen.

Beim Beschichten wird das Bauteil 1, 120, 130, 155 mit der Maskierung 7 so warm, dass der glasartige Anteil der Pulvermischung schon aufschmilzt und so eine dichte, feste Schicht bildet.

Bei der Erhitzung in einem Beschichtungsreaktor, wie z.B. in einem Gasphasenreaktor umschließt der schmelzende oder erweichende Pulverbestandteil sowohl die anderen Partikel des Pulvers als auch die Außenkontur des Bauteiles an der Grenzfläche Schutzschicht/Bauteil. Die sich so einstellende Schutzschicht gleicht jetzt einer hochviskosen Paste, die begrenzt fließfähig ist, aber trotzdem gasdicht und zudem stark diffusionshemmend ist. Die Schutzschicht 7 wird dadurch duktil und neigt nicht zur Rissbildung, wie es von anderen Schutzschichten ohne schmelzende oder erweichende Pulverkomponente bekannt ist und haftet besser an der Bauteiloberfläche. Bei der Abkühlung erstarrt die glasartige Pulverkomponente wieder zu einem sehr spröden monolithischen Verbund aus einer glasartigen Keramik mit eingelagerten höherschmelzenden Keramikpartikeln, der sich vorzugsweise durch vorsichtiges Abklopfen oder Sandstrahlen entfernen lässt.

In Figur 2 ist eine Maskierung dargestellt.
Wird vorzugsweise ein Plasmaspritzverfahren mit einem Plasmabrenner 10 verwendet, so erwärmt dieser Plasmabrenner auch die Maskierung 7, so dass ein oberer Schichtbereich 16 in der Maskierung 7 entsteht, der eine dichte, feste Schicht darstellt mit einem unteren Schichtbereich 13, in dem das Material noch nicht aufgeschmolzen ist (13 und 16 haben hier die gleiche chemische Zusammensetzung).

Es kann jedoch sein, dass die gesamte Maskierung 7 (also das gesamte Glas) aufschmilzt und eine gesamte stabile dichte Schicht bildet.

Ebenso kann es sein, dass vor dem eigentlichen Behandlungsverfahren, dem Beschichten oder dem Schweißen eine Erwärmung mittels einer Wärmequelle (Plasmabrenner, Laser) 25 verwendet wird, um einen äußeren Schichtbereich der Maskierung 7 aufzuschmelzen oder die gesamte Schicht aufzuschmelzen, um eine dichte feste Schicht zu erreichen, wobei nach diesem Vorbehandlungsschritt das eigentliche Behandlungsverfahren (Schweißen, Beschichten) startet.

Ebenso ist es möglich, dass eine zweischichtige Maskierung 7 verwendet wird (Fig. 3), bei der nur der obere Schichtanteil 22 (vorzugsweise mindestens 50% der Gesamtschichtdicke) der Maskierung 7 diese Pulvermischung aus Keramik und Glas, enthält, aber der untere Anteil 19 nicht, sondern eine andere Zusammensetzung aufweist.

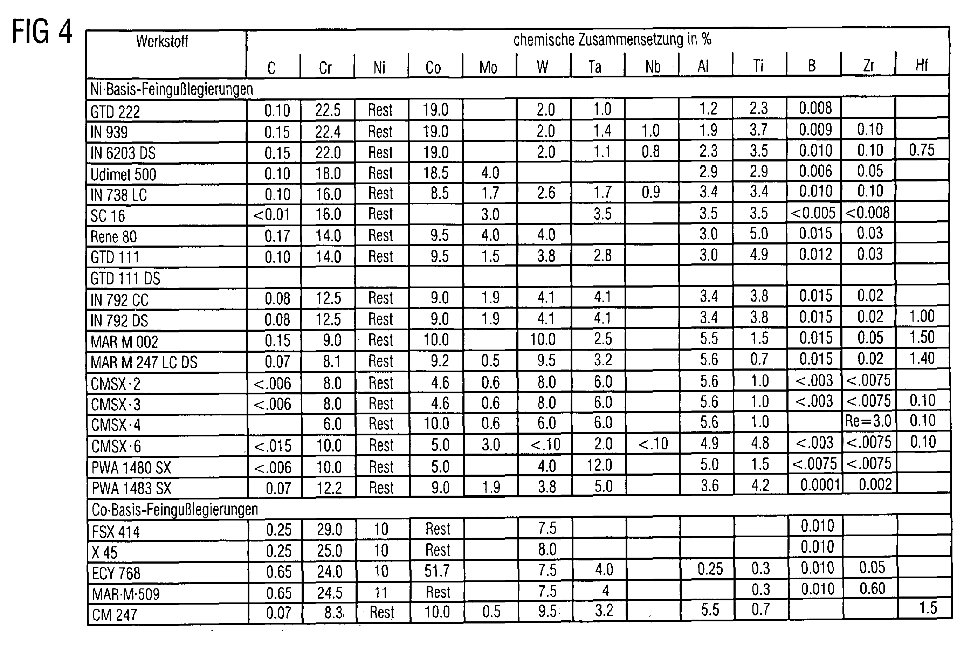

Die Figur 4 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

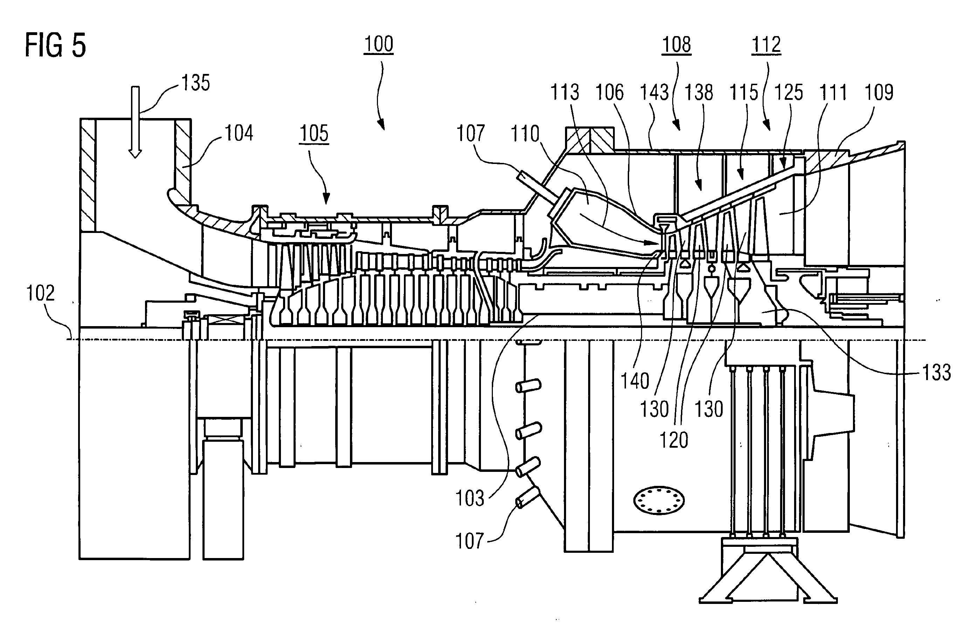

Die Figur 5 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder. Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.
Die Dichte liegt vorzugsweise bei 95% der theoretischen Dichte.
Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8A1-0,6Y-0,7Si oder Co-28Ni-24Cr-10A1-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11A1-0,4Y-2Re oder Ni-25Co-17Cr-10A1-0,4Y-1,5Re.

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

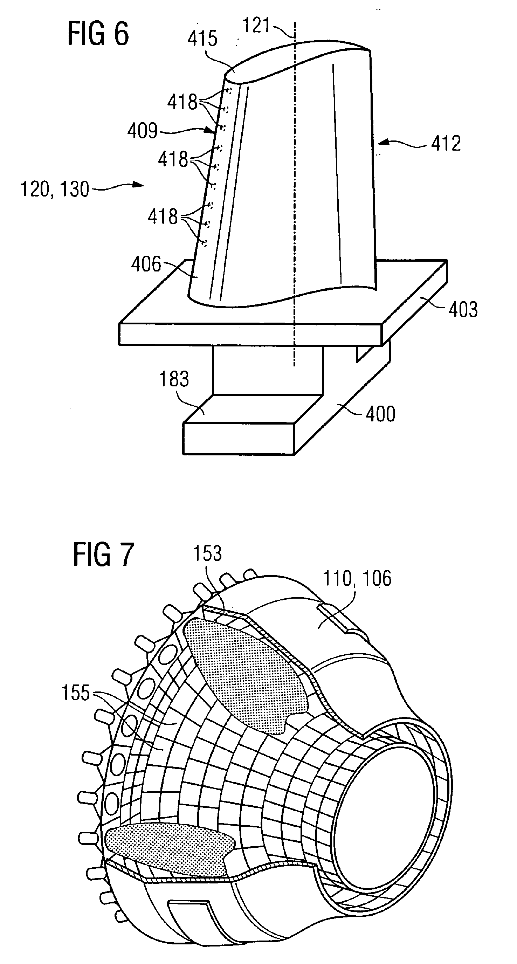

Die Figur 6 zeigt eine Brennkammer 110 der Gasturbine 100. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1.

Auf der MCrAlX kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Turbinenschaufeln 120, 130, Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in der Turbinenschaufel 120, 130 oder dem Hitzeschildelement 155 repariert. Danach erfolgt eine Wiederbeschichtung der Turbinenschaufeln 120, 130, Hitzeschildelemente 155 und ein erneuter Einsatz der Turbinenschaufeln 120, 130 oder der Hitzeschildelemente 155.

## Patentansprüche

1. Pulvermischung aus Keramik und Glas.

2. Pulvermischung nach Anspruch 1,
bei dem die Keramik und/oder das Glas als Pulverteilchen vorliegen,
vorzugsweise Keramik und Glas als Pulverteilchen vorliegen.

3. Pulvermischung nach Anspruch 1 oder 2,
die nur aus Keramik und Glas besteht.

4. Pulvermischung nach Anspruch 1, 2 oder 3,
die nur ein einziges Keramikmaterial und/oder vorzugsweise nur ein einziges Glasmaterial aufweist,
ganz vorzugsweise nur ein einziges Keramikmaterial und nur ein einziges Glasmaterial.

5. Pulvermischung nach Anspruch 1, 2, 3 oder 4,
bi dem die Keramik eine Oxid-, Nitrid- oder Karbidkeramik darstellt.

6. Pulvermischung nach Anspruch 1, 2, 3 oder 4,
bei dem die Keramik Aluminiumoxid (Al₂O₃), Zirkonoxid (ZrO₂), Titanoxid (TiO₂) und/oder Bornitrid (BN) aufweist.

7. Pulvermischung nach Anspruch 1, 2, 3 oder 4,
bei dem das Glas ein siliziumoxidbasiertes Glas darstellt.

8. Bauteil (120, 130, 155) mit Maskierung (7)
nach einem oder mehreren der vorherigen Ansprüchen.

9. Bauteil nach Anspruch 8,
bei dem die Maskierung (7) zumindest lokal aufgeschmolzen war.

10. Bauteil nach Anspruch 8 oder 9,
bei dem bei dem die Maskierung (7) zweischichtig ausgebildet ist,
und nur ein äußerer Schichtbereich (22) eine Pulvermischung (7) nach einem oder mehreren der Ansprüche 1, 2, 3, 4, 5, 6 oder 7 aufweist.

11. Bauteil nach Anspruch 8 oder 9,
bei dem nur ein oberer Schichtbereich (16) der Maskierung (7) aufgeschmolzen war.

12. Verfahren zum Behandeln eines Substrats (4) eines Bauteils (1, 120, 130, 155),
bei dem eine Maskierung (7) aus einer Pulvermischung nach einem oder mehreren der vorherigen Ansprüche 1 bis 7 aufgetragen wird und
die Behandlung durchgeführt wird.

13. Verfahren nach Anspruch 12,
bei dem die Maskierung (7) vor der Behandlung zumindest lokal aufgeschmolzen wird.

14. Verfahren nach Anspruch 12 oder 13,
bei dem die Maskierung (7) zweischichtig ausgebildet ist, und nur ein äußerer Schichtbereich (22) eine Pulvermischung (7) nach einem oder mehreren der Ansprüche 1, 2, 3, 4, 5, 6 oder 7 aufweist.

15. Verfahren nach Anspruch 12 oder 13,
bei dem nur ein oberer Schichtbereich (16) der Maskierung (7) aufgeschmolzen wird.

16. Verfahren nach Anspruch 12 oder 13,
bei dem die Maskierung (7) beim Schweißen oder Beschichten von Bauteilen (1, 120, 130, 155) verwendet wird.
